# EUROPÄISCHE PATENTSCHRIFT

(11) **EP 1 550 154 B1**
(45) Veröffentlichungstag und Bekanntmachung des Hinweises auf die Patenterteilung: **18.02.2015**
(21) Anmeldenummer: 03750362.0
(22) Anmeldetag: 19.09.2003
(51) Int. Cl.: H01L 21/336, H01L 29/06, H01L 29/78

(54) **FELDEFFEKTTRANSISTOR MIT LOKALER SOURCE-/DRAINISOLATION SOWIE ZUGEHÖRIGES HERSTELLUNGSVERFAHREN**
FIELD EFFECT TRANSISTOR WITH LOCAL SOURCE/DRAIN INSULATION AND ASSOCIATED METHOD OF PRODUCTION
TRANSISTOR A EFFET DE CHAMP POURVU D'UNE ISOLATION SOURCE/DRAIN LOCALE ET PROCEDE DE PRODUCTION ASSOCIE

(30) Priorität: 07.10.2002 DE 10246718
(43) Veröffentlichungstag der Anmeldung: 06.07.2005
(60) Teilanmeldung: 13177706.2
(73) Patentinhaber: Infineon Technologies AG, 85579 Neubiberg (DE)
(72) Erfinder: HOLZ, Jürgen, 01127 Dresden (DE); SCHRÜFER, Klaus, 85598 Baldham (DE); TEWS, Helmut, 81549 München (DE)
(74) Vertreter: Kindermann, Peter
(86) Internationale Anmeldenummer: PCT/DE2003/003130
(87) Internationale Veröffentlichungsnummer: WO 2004/034458

(56) Entgegenhaltungen:
- WO-A-01/50535
- WO-A-02/43109
- DE-A- 19 749 378
- DE-C- 19 812 643
- US-A- 5 043 778
- US-A- 5 620 912
- US-A- 5 908 313
- US-A- 5 949 116
- US-A1- 2001 017 387
- US-A1- 2001 025 998
- US-A1- 2002 142 552
- US-B1- 6 346 729
- US-B1- 6 399 973
- US-B1- 6 403 482
- ANANTHA N G ET AL: "SELF-ALIGNED IGFET WITH SILICON DIOXIDE ISOLATED SOURCE AND DRAIN" IBM TECHNICAL DISCLOSURE BULLETIN, IBM CORP. NEW YORK, US, Bd. 22, Nr. 11, April 1980 (1980-04), Seiten 4895-4899, XP000806625 ISSN: 0018-8689
- ELBEL N ET AL: "A new STI process based on selective oxide deposition Yfor CMOS logic" VLSI TECHNOLOGY, 1998. DIGEST OF TECHNICAL PAPERS. 1998 SYMPOSIUM ON HONOLULU, HI, USA 9-11 JUNE 1998, NEW YORK, NY, USA,IEEE, US, 9. Juni 1998 (1998-06-09), Seiten 208-209, XP010291189 ISBN: 0-7803-4770-6 in der Anmeldung erwähnt

## Beschreibung

Die vorliegende Erfindung bezieht sich auf einen Feldeffekttransistor mit lokaler Source-/Drainisolation sowie ein zugehöriges Herstellungsverfahren und insbesondere auf einen Feldeffekttransistor mit Strukturen im sub100nm-Bereich, der in so genannten Mixed-Signal-Schaltungen verwendet werden kann.

Die elektrischen Eigenschaften von Feldeffekttransistoren werden von einer Vielzahl von Parametern beeinflusst, wobei insbesondere so genannte Junction-Kapazitäten unerwünschte parasitäre Effekte im Feldeffekttransistor hervorrufen. Derartige Junction-Kapazitäten werden insbesondere an den pn-Übergängen der Source- und Draingebiete im Halbleitersubstrat verursacht, da an dieser Stelle aufgrund von Raumladungs- bzw. Verarmungszonen relativ hohe parasitäre Kapazitäten entstehen.

Zur Vermeidung bzw. zur Verkleinerung derartiger Junction-Kapazitäten wurden herkömmlicherweise so genannte SOI-Substrate (Silicon On Insulator) benutzt, wodurch zumindest ein unterer Bereich von jeweiligen Source- und Draingebieten unmittelbar vom Isolationsgebiet des SOI-Substrats bzw. - Wafers begrenzt wurde. Nachteilig bei derartigen Halbleiterschaltungen in einem SOI-Substrat sind jedoch die deutlich erhöhten Kosten sowie die damit einhergehenden Nachteile bei so genannten Mixed-Signal-Schaltungen. Während bei Kurzkanal-Feldeffekttransistoren ein vollständig verarmtes Kanalgebiet (fully depleted) oftmals sogar erwünscht ist, benötigen Feldeffekttransistoren mit langen Kanalgebieten eine Anschlussmöglichkeit zur Vermeidung einer Aufladung dieser Gebiete und zur Realisierung einer möglichst hohen Linearität der Kennlinien. In gleicher Weise ist eine Anschlussmöglichkeit des Kanalgebietes auch für das für das so genannte Matchingverhalten der Transistoren von Bedeutung, um beispielsweise ein gleiches Verhalten von zwei gleichen Transistoren in einer Halbleiterschaltung zu ermöglichen. Insbesondere für Mixed-Signal-Schaltungen liefert daher die Verwendung von SOI-Substraten nur unzureichende Ergebnisse. Ferner besitzen SOI-Substrate nur eine schlechte thermische Anbindung der aktiven Gebiete.

Aus der Druckschrift DE 198 12 643 C ist ein Feldeffekttransistor mit lokaler Source-/Drainisolation sowie ein zugehöriges Herstellungsverfahren bekannt, wobei eine Sourcevertiefung und eine Drainvertiefung in einem Halbleitersubstrat voneinander beabstandet ausgebildet werden. Im Bodenbereich der Source- und Drainvertiefung wird zunächst eine Vertiefungs-Isolationsschicht ausgebildet und anschließend eine elektrisch leitende Füllschicht zur Realisierung von Source- und Draingebieten und zum Auffüllen der Source- und Drainvertiefungen an der Oberfläche der Vertiefungs-Isolationsschicht ausgebildet. Zur Realisierung eines Feldeffekttransistors sind ein Gatedielektrikum an der Substratoberfläche zwischen der Source- und Drainvertiefung und eine Gateschicht an der Oberfläche des Gatedielektrikums ausgebildet.

Aus der Druckschrift US-B1-6 346 729 ist lediglich ein MOSFET sowie ein zugehöriges Herstellungsvefahren bekannt, bei dem die Kanal-Anschlussbereiche in üblicher Weise durch Ionen-Implantation ausgebildet sind. Weitere Teilbereiche der Source/Draingebiete sind hierbei als Füllschicht in einer Vertiefung mit Verbreiterung realisiert, die eine Vertiefungs-Isolationsschicht aufweist.

Aus der weiteren Druckschrift US-A- 5 949 116 sind die Merkmale bekannt, wonach eine im Seitenwandbereich der Source- und Drainvertiefungen ausgebildete Vertiefungs-Seitenwandisolationsschicht vorliegt und ferner eine Polyschicht als Keimschicht zunächst in den Vertiefungen abgeschieden wird.

Auch bei der weiteren Druckschrift DE 197 49 378 A1 sind lediglich herkömmliche in einem Halbleitersubstrat ausgebildete Diffusionsgebiete offenbart, die in Kontakt mit epitaktisch abgeschiedenen Halbleiterschichten stehen.

Die Druckschriften US-A-5 908 313 und US 2002/142552 A1 zeigen ebenfalls nur herkömmliche Feldeffekttransistoren, wobei die Kanal-Anschlussbereiche der jeweiligen Source-/Draingebiete durch Ionen-Implantation ausgebildet sind.

Die Druckschrift US-A-5 043 778 offenbart einen MOSFET, bei dem keine Verbreiterung der Vertiefungen sondern nur eine Rückbildung des Gatedielektrikums vorliegt, weshalb keine hochgenau definierten Kanal-Anschlussbereiche realisiert werden können.

In ähnlicher Weise zeigt auch die Druckschrift WO 02/43109 A2 eine Vertiefung, die aufgrund der verwendeten Ätzverfahren in ihrem oberen Bereich breiter als in ihrem unteren Bereich ist. Zur Vermeidung einer Diffusion der sich im Source-/Drain-Bereich befindlichen Dotieratome ist hierbei eine Diffusions-Barrierenschicht vorgesehen, welche jedoch ein Tunneln elektrischer Ladungsträger ermöglicht.

Die weiteren Druckschriften US-A-5 620 912, US-A-6 403 482, WO 01/50535 A, US 2001/025998 A1 sowie die Literaturstelle

Anantha et al.: "Self-aligned IGFET with Silicon..." IBM Technical Disclosure zeigen lediglich weitere herkömmliche Feldeffekttransistoren sowie zugehörige Herstellungsverfahren, wobei jedoch eine Verbreiterung mit vorbestimmter Tiefe in einem oberen Bereich der Source- und Drainvertiefungen zur Realisierung von definiert flachen Kanal-Anschlussbereichen nicht bekannt ist.

Aus US 6399973 ist ein MOSFET bekannt, der Oxidisolationsbereiche unter Source und Drain aufweist.

Aus der Druckschrift JP 021 28 430 A ist ein Verfahren zur Herstellung eines Feldeffekttransistors bekannt, wobei zur Erzeugung von lokalen Source-/Drainisolationen eine Sauerstoffimplantation derart durchgeführt wird, dass Sauerstoffionen unmittelbar unterhalb der Source- und Draingebiete im Halbleitersubstrat implantiert und anschließend in eine vergrabene Siliziumdioxidschicht umgewandelt werden. Nachteilig ist hierbei jedoch die relativ ungenaue Ausbildung dieser vergrabenen Isolationsgebiete wie zum Beispiel ein unscharfer lateraler Übergang zwischen implantierten und nicht-implantierten Bereich, und insbesondere eine fehlende Anwendbarkeit derartiger Verfahren für Feldeffekttransistoren mit Strukturen im sub100nm-Bereich.

Der Erfindung liegt daher die Aufgabe zugrunde, einen Feldeffekttransistor mit lokaler Source-/Drainisolation sowie ein zugehöriges Herstellungsverfahren zu schaffen, wobei Junction-Kapazitäten besonders einfach verringert werden und Mixed-Signal-Schaltungen besonders einfach realisiert werden können.

Erfindungsgemäß wird diese Aufgabe hinsichtlich des Feldeffekttransistors durch die Merkmale des Patentanspruchs 1 und hinsichtlich des Herstellungsverfahrens durch die Maßnahmen des Patentanspruchs 7 gelöst.

Zur einfachen Realisierung von Mixed-Signal-Schaltungen können demzufolge die Source- und Drainvertiefungen im oberen Bereich eine erste Vertiefung mit einer vorbestimmten Tiefe und eine zweite Vertiefung in der ersten Vertiefung und im Halbleitersubstrat aufweisen, wobei sich die Vertiefungs-Seitenwandisolationsschicht auch in einen Bereich unterhalb des Gatedielektrikums bzw. unterhalb des Kanalgebietes hinein erstreckt ohne das Gatedielektrikum zu berühren. Auf diese Weise können die gewünschten flachen Anschlussbereiche für die Kanalgebiete sehr präzise realisiert werden und es entfallen die üblicherweise angewendeten sehr flachen Implantationen, die Probleme durch diffusionsfördernde Wirkungen von Defekten sowie sehr kurze RTP-Ausheilschritte (Rapid Thermal Process) mit ihrer schlechten Reproduzierbarkeit oder eine Prä-Amorphisierung und Defektimplantationen. Aufgrund der Vertiefungs-Seitenwandisolationsschichten können jedoch die üblicherweise auftretenden hohen Leckströme sowie Junction-Kapazitäten in diesem Bereich wesentlich verringert werden. Man kann dadurch ferner erreichen, dass Kurzkanaltransistoren vom Substrat isoliert werden und Langkanaltransistoren auf demselben Wafer eine Anschlussmöglichkeit an das Substrat erhalten. So werden sowohl für Digitalschaltungen als auch für Mixed-Signal-Schaltungen die optimalen Devices erzeugt. Dies ist besonders vorteilhaft für eine SoC (System on Chip) Integration.

Da die Vertiefungs-Seitenwandisolationsschicht das Gatedielektrikum nicht berührt, erhält man weiter verringerte Junction-Kapazitäten und flache bzw. genau definierte Extensions bzw. Anschlussbereiche für das Kanalgebiet.

Zur Verbesserung eines Abscheidevorgangs in den Source- und Drainvertiefungen kann die elektrisch leitende Füllschicht eine Keimschicht aufweisen, wodurch auch sehr schmale und tiefe Source- und Drainvertiefungen bzw. Löcher ausreichend gut aufgefüllt werden können.

In den weiteren Ansprüchen sind weitere vorteilhafte Ausgestaltungen der Erfindung gekennzeichnet.

Die Erfindung wird nachfolgend an Hand von Beispielen unter Bezugnahme auf die Zeichnung näher beschrieben.

Es zeigen:
- Figur 1: eine vereinfachte Schnittansicht eines Feldeffekttransistors mit lokaler Source-/Drainisolation;
- Figur 2: eine vereinfachte Schnittansicht eines Feldeffekttransistors mit lokaler Source-/Drainisolation;
- Figuren 3A bis 3I: vereinfachte Schnittansichten zur Veranschaulichung wesentlicher Verfahrensschritte bei der Herstellung eines Feldeffekttransistors mit lokaler Source-/Drainisolation;
- Figur 4: eine teilvergrößerte Schnittansicht eines Feldeffekttransistors, der gemäß der Figuren 3A bis 3I hergestellt ist; und
- Figuren 5A und 5B: vereinfachte Schnittansichten zur Veranschaulichung wesentlicher Verfahrensschritte bei der Herstellung eines Feldeffekttransistors mit lokaler Source-/Drainisolation gemäß einem Ausführungsbeispiel.

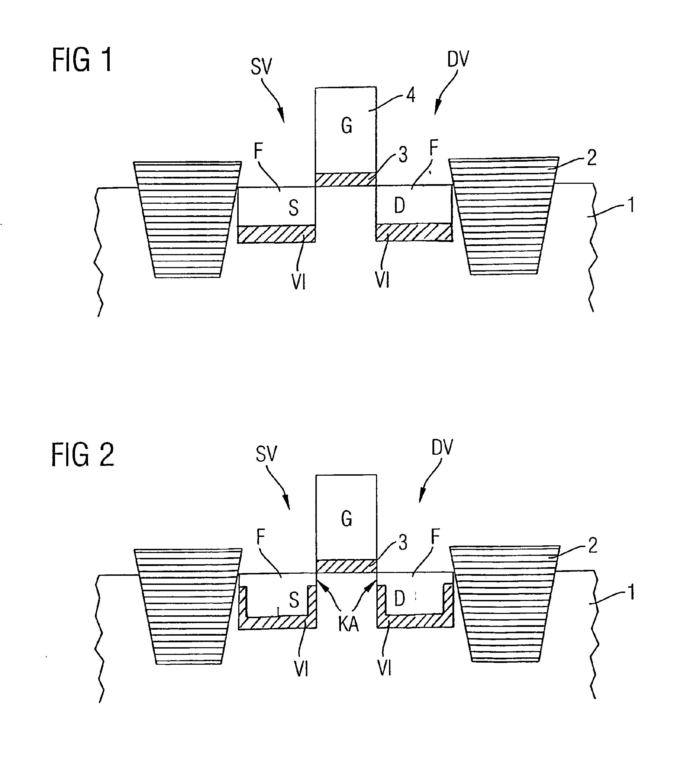

Figur 1 zeigt eine vereinfachte Schnittansicht eines Feldeffekttransistors mit lokaler Source-/Drainisolation gemäß einem ersten Beispiel, wobei in einem Halbleitersubstrat 1, welches vorzugsweise aus einem Siliziumhalbleitermaterial besteht, aktive Gebiete mittels eines STI-Verfahrens (Shallow Trench Isolation) zur Ausbildung von flachen Grabenisolierungen 2 ausgebildet werden. Diese flachen Grabenisolierungen 2 können beispielsweise streifenförmig im Halbleitersubstrat 1 ausgebildet sein, wodurch sich dazwischenliegende streifenförmige aktive Gebiete ergeben.

Der Feldeffekttransistor weist hierbei einen an der Oberfläche des Halbleitersubstrats 1 ausgebildeten Gatestapel G auf, der im Wesentlichen ein Gatedielektrikum wie z.B. eine Gateoxidschicht 3 sowie eine eigentliche Gate- bzw. Steuerschicht 4 aufweist. An den Seiten des Gatestapels G sind nunmehr im Halbleitersubstrat 1 eine Sourcevertiefung SV und eine Drainvertiefung DV voneinander beabstandet ausgebildet, wobei ein unterhalb des Gatedielektrikums 3 liegender Bereich ein Kanalgebiet darstellt. Als Vertiefungen können hierbei Aussparungen, Löcher, Gräben usw. mit einer entsprechenden Tiefe im Halbleitersubstrat 1 ausgebildet werden.

Gemäß Figur 1 ist in einem Bodenbereich der Sourcevertiefung SV und der Drainvertiefung DV jeweils eine Vertiefungs-Isolationsschicht VI ausgebildet, die eine lokale Source- und Drainisolation zum Halbleitersubstrat 1 darstellt und somit eine Junction-Kapazität eines jeweiligen Source- und Draingebietes wesentlich verringert. Im Gegensatz zu herkömmlichen mittels Sauerstoffimplantationen ausgebildeten Vertiefungs-Isolationsschichten sind die lokalen Source- und Drainisolationen eng begrenzt und sehr exakt in der Vertiefung ausgebildet. Ferner weist der Feldeffekttransistor eine elektrisch leitende Füllschicht F zur Realisierung der eigentlichen Source- und Draingebiete S und D auf, wobei die Füllschicht F an der Oberfläche der Vertiefungs-Isolationsschicht ausgebildet ist und die Source- und Drainvertiefungen SV und DV auffüllt.

Auf diese Weise erhält man einen Feldeffekttransistor mit lokaler Source- und Drainisolation, der eine wesentlich verringerte Junction-Kapazität an seinen Source- und Draingebieten S und D aufweist und darüber hinaus eine Anschlussmöglichkeit des zwischen dem Source- und Draingebiet liegenden Kanalgebietes ermöglicht. Auf diese Weise können insbesondere in Mixed-Signal-Schaltungen auch Feldeffekttransistoren mit langen Kanälen und hoher Linearität sowie hervorragenden Matchingeigenschaften realisiert werden. Ferner erhält man bei einer derartigen lokalen Source- und Drainisolation auch eine gegenüber SOI-Substraten weit verbesserte thermische Anbindung der Kanalgebiete an das Halbleitersubstrat 1. Insbesondere bei Feldeffekttransistoren mit lateralen Strukturen im sub100nm-Bereich bzw. < 100 nm können somit Feldeffekttransistoren mit weiter verbesserten elektrischen Eigenschaften auf relativ einfache Weise hergestellt werden. Abhängig von einer jeweiligen Art der Herstellung der Vertiefungs-Isolationsschicht VI und jeweiligen Abmessungen des Feldeffekttransistors können die Source- und Drainvertiefungen eine Tiefe von ca. 50 bis 300 nm aufweisen. Insbesondere bei senkrechten Seitenwänden der Vertiefungen SV und DV können hierbei die elektrischen Eigenschaften des Feldeffekttransistors sehr genau eingestellt werden.

Als Gatedielektrikum wird beispielsweise Siliziumdioxid verwendet, wobei jedoch auch andere dielektrische Schichten verwendet werden können. Als Gateschicht 4 wird vorzugsweise amorphes Silizium oder Polysilizium verwendet, wobei jedoch auch Metallgates oder andere Materialien Verwendung finden können. Insbesondere können für den Gatestapel G auch andere Schichtstrukturen realisiert werden, wie sie beispielsweise aus dem Bereich von nichtflüchtigen Speicherelementen bekannt sind (Flash-EPROM, E²PROM usw.).

Figur 2 zeigt eine vereinfachte Schnittansicht eines Feldeffekttransistors mit lokaler Source-/Drainisolation gemäß einem zweiten Beispiel, wobei gleiche Bezugszeichen gleiche oder entsprechende Elemente bzw. Schichten bezeichnen wie in Figur 1 und auf eine wiederholte Beschreibung nachfolgend verzichtet wird.

Im Beispiel gemäß Figur 2 besitzt die Vertiefungs-Isolationsschicht VI nicht nur eine im Bodenbereich der Source- und Drainvertiefungen SV und DV ausgebildete Vertiefungs-Bodenisolationsschicht, sondern darüber hinaus eine Vertiefungs-Seitenwandisolationsschicht, die jedoch das Gatedielektrikum 3 nicht berührt und somit einen definierten Kanal-Anschlussbereich KA zum Anschließen eines unter dem Gatedielektrikum 3 liegenden Kanalgebietes ermöglicht. Auf diese Weise erhält man Kanal-Anschlussbereiche KA, die sehr geringe Leckströme und weiter verringerte Junction-Kapazitäten aufweisen. Die üblicherweise verwendeten Verfahren zur Ausbildung von derartig flachen Anschlussbereichen mittels flacher Implantationen, Prä-Amorphisierung oder Defektimplantationen sowie kurze RTP-Ausheilschritte (Rapid Thermal Process) können somit vermieden werden. Aufgrund der sehr genau einstellbaren Abmessungen der Source- und Drainvertiefungen lassen sich auch die elektrischen Eigenschaften der damit ausgebildeten Feldeffekttransistoren sehr genau festlegen, wodurch man Halbleiterbauelemente mit wesentlich verringerten Junction-Kapazitäten erhält.

Die Extensions bzw. Anschlussbereiche KA können bei Verwendung von Polysilizium als Füllschicht F mittels Ausdiffusion realisiert werden, wodurch sich Dotierstoffprofile mit maximalem Gradienten ergeben.

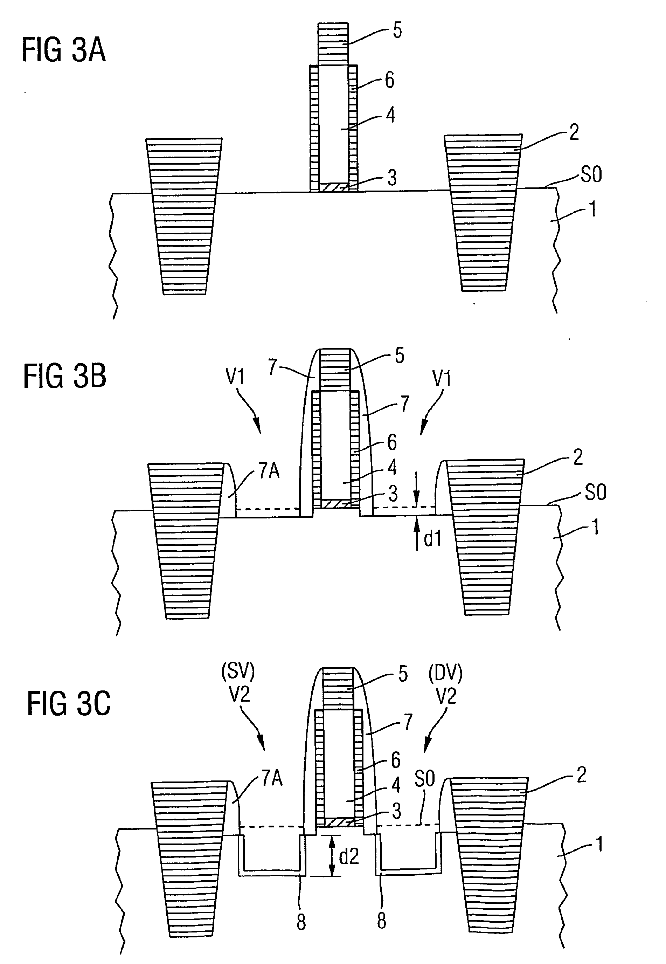

Figuren 3A bis 3I zeigen vereinfachte Schnittansichten zur Veranschaulichung wesentlicher Verfahrensschritte bei der Herstellung eines Feldeffekttransistors mit lokaler Source-/Drainisolation, wobei wiederum gleiche Bezugszeichen gleiche oder ähnliche Schichten bzw. Elemente wie in den Figuren 1 und 2 bezeichnen und auf eine wiederholte Beschreibung nachfolgend verzichtet wird.

Gemäß Figur 3A wird zunächst in einem vorbereitenden Verfahren ein Gatestapel mit einer Gateschicht 4 und einem Gatedielektrikum 3 auf einem Halbleitersubstrat 1 ausgebildet. Bei einem derartigen üblicherweise als Gateprozess bezeichneten Verfahren wird zunächst ein (nicht dargestelltes) Padoxid an der Oberfläche des Halbleitersubstrats 1 abgeschieden und anschließend ein (nicht dargestelltes) Padnitrid an der Oberfläche des Padoxids ausgebildet. Anschließend wird mittels eines herkömmlichen STI-Verfahrens (Shallow Trench Isolation) eine flache Grabenisolierung 2 im Halbleitersubstrat 1 ausgebildet und daraufhin zumindest die Padnitridschicht wieder entfernt. Im Weiteren erfolgt eine oder mehrere Implantationen zur Ausbildung von Wannen- und/oder Kanaldotiergebieten im Halbleitersubstrat 1, wobei je nach auszubildender Halbleiterschaltung auch ein Mehrfach-Wannenaufbau realisiert werden kann. Anschließend erfolgt zur Ausbildung des Gatedielektrikums 3 vorzugsweise eine thermische Oxidation der Substratoberfläche SO, wodurch z.B. ein hochwertiges Gateoxid ausgebildet wird. Anschließend erfolgt zur Ausbildung der Gateschicht 4 beispielsweise eine Abscheidung von Polysilizium mit einer Dicke von beispielsweise 100 nm und an deren Oberfläche zur Ausbildung einer Hartmaskenschicht 5 beispielsweise eine TEOS-Isolationsschicht mit einer Dicke von ca. 50 nm abgeschieden wird. Zur Strukturierung von zumindest der Gateschicht 4 wird anschließend ein fotolithografisches Verfahren zunächst auf die Hartmaskenschicht 5 angewendet, wobei anschließend unter Verwendung der strukturierten Hartmaskenschicht 5 vorzugsweise mittels eines anisotropen Ätzverfahrens (RIE, Reactive Ionetching) die Gateschicht 4 strukturiert wird. Abschließend kann eine weitere thermische Oxidation oder Oxid-Abscheidung zur Ausbildung einer Gate-Seitenwandisolationsschicht 6 an den Seitenwänden der Gateschicht 4 durchgeführt werden, wodurch man eine ca. 6 nm dicke Schutzschicht erhält. Die Gate-Seitenwandisolationsschicht 6 dient hierbei als Ätzstoppschicht für spätere Ätzschritte sowie als seitliche Schutzschicht für das relativ empfindliche Gatedielektrikum 3.

Auf diese Weise erhält man die in Figur 3A dargestellte Schnittansicht, wobei auch alternative Verfahren zum Ausbilden und Strukturieren eines Gatestapels mit einer Gateschicht 4 und einem Gatedielektrikum 3 auf einem Halbleitersubstrat 1 durchgeführt werden können.

Anschließend werden im Halbleitersubstrat 1 Source- und Drainvertiefungen am Gatestapel ausgebildet.

Gemäß Figur 3B können beispielsweise zunächst erste Vertiefungen V1 zur Realisierung von Kanal-Anschlussbereichen KA im Halbleitersubstrat 1 ausgebildet werden, wobei vorzugsweise mittels eines anisotropen Ätzverfahrens wie z.B. RIE (Reactive Ion Etching) aber auch nasschemisch eine d1 = 10 bis 50 nm tiefe Aussparung ausgebildet wird. Die Tiefe dieser ersten Vertiefung V1 dient hierbei als Optimierungsparameter für die Herstellung der Extension bzw. des Kanal-Anschlussbereiches.

Optional kann zu diesem Zeitpunkt eine (nicht dargestellte) erste dünne Halbleiter-Schutzschicht zumindest im Bereich des Kanal-Anschlussbereiches KA und vorzugsweise ganzflächig ausgebildet werden, um die Halbleiteroberfläche (Silizium) vor einer nachfolgenden Nitridabscheidung zu schützen, die im Allgemeinen problematisch für Siliziumhalbleitermaterialien ist. Vorzugsweise besteht diese erste Halbleiterschutzschicht demzufolge aus einer Siliziumoxidschicht.

Anschließend werden gemäß Figur 3B Spacer 7 am Gatestapel ausgebildet, wobei der Gatestapel sich im Wesentlichen aus dem Gatedielektrikum 3, der Gateschicht 4, der Hartmaskenschicht 5 und der (eventuell vorhandenen) Gate-Seitenwandisolationsschicht 6 zusammensetzt. Vorzugsweise werden die Spacer 7 durch konformales, d.h. gleichmäßig dickes, Abscheiden von Siliziumnitrid auf der zur Verfügung stehenden Oberfläche und einem nachfolgenden anisotropen Rückätzen ausgebildet, wobei für die Abscheidung beispielsweise ein LPCVD-Verfahren (Low Pressure Chemical Vapor Deposition) verwendet wird. Wiederum ist auch die Dicke der Spacer 7 ein Optimierungsparameter für den Kanal-Anschlussbereich KA, wobei vorzugsweise Spacerdicken von ca. 10 bis 30 nm besonders günstige Anschlusseigenschaften ergeben.

Vorzugsweise werden die ersten Vertiefungen V1 unter Verwendung des Gatestapels und der flachen Grabenisolierung 2 als Maske ausgebildet, wodurch man im Wesentlichen selbstjustierende Verfahren für eine erste Vertiefung V1 erhält.

Gemäß Figur 3C werden nunmehr unter Verwendung der am Gatestapel ausgebildeten Spacer 7 sowie der an der flachen Grabenisolierung 2 ausgebildeten weiteren Spacer 7A als Maske innerhalb der ersten Vertiefungen V1 zweite Vertiefungen V2 im Halbleitersubstrat 1 ausgebildet. Genauer gesagt wird beispielsweise mittels eines Silizium-RIE-Verfahrens eine zweite Vertiefung V2 mit einer Tiefe d2 von ca. 40 bis 250 nm ausgebildet, wodurch sich eine Gesamttiefe für die Source- und Drainvertiefungen SV und DV von d1 + d2 = ca. 50 bis 300 nm, von der Substratoberfläche SO gemessen, ergibt.

Abschließend erfolgt zur Ausbildung einer Vertiefungs-Isolationsschicht zumindest in einem Bodenbereich der Source- und Drainvertiefungen SV und DV zunächst eine Ausbildung einer Isolations-Maskenschicht 8. Vorzugsweise erfolgt hierbei eine Nitrierung des exponierten Halbleitermaterials bzw. Siliziums mit NH₃ innerhalb eines Temperaturbereiches von 600 bis 900°C. Alternativ kann jedoch auch eine Nitridabscheidung zur Realisierung der Isolations-Maskenschicht 8 durchgeführt werden. Die angestrebte Siliziumnitriddicke bzw. Dicke der Isolations-Maskenschicht 8 beträgt beispielsweise ca. 1 bis 5 nm. Grundsätzlich kann wiederum eine zusätzliche dünne Oxid-Pufferschicht (nicht dargestellt) unter dem abgeschiedenen Nitrid zum Schutz des Halbleitermaterials erzeugt werden.

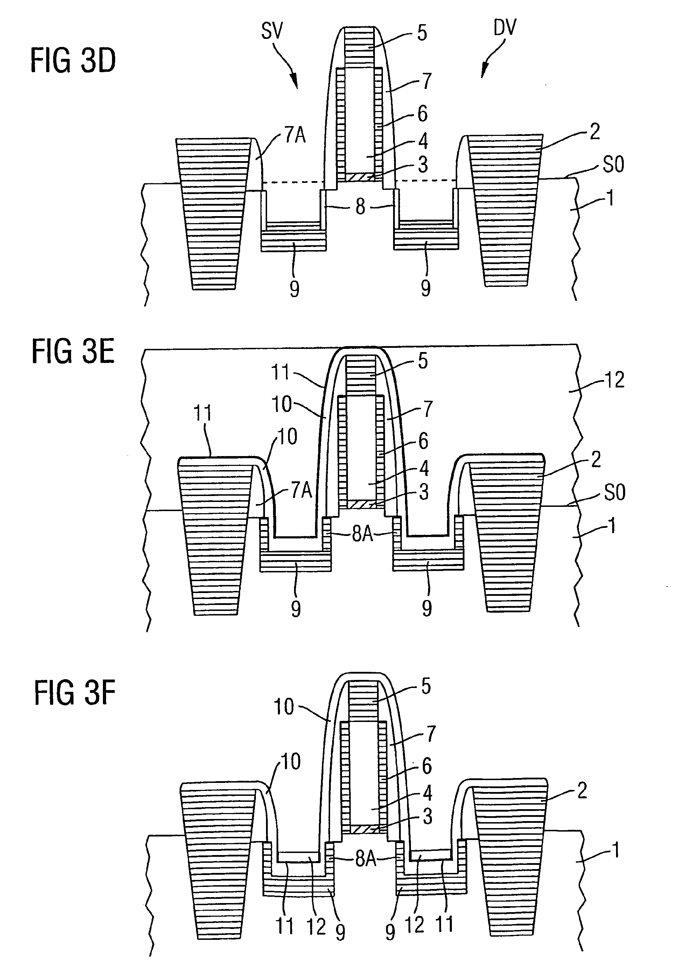

Gemäß Figur 3D erfolgt in einem nachfolgenden Schritt ein Entfernen der Isolations-Maskenschicht 8 zumindest im Bodenbereich der Source- und Drainvertiefungen SV und DV, wobei vorzugsweise ein anisotropes Ätzverfahren und insbesondere ein RIE-Nitridätzverfahren zum Freilegen der Bodenbereiche durchgeführt wird. Bei einer ganzflächigen Abscheidung der Isolations-Maskenschicht 8 werden hierbei lediglich die horizontalen Flächen freigelegt.

Anschließend wird eine Vertiefungs-Bodenisolationsschicht 9 jeweils in den freigelegten Bodenbereichen der Source- und Drainvertiefungen SV und DV ausgebildet, wobei beispielsweise eine thermische Oxidation auf das freigelegte Halbleitermaterial durchgeführt wird. Hierdurch wird beispielsweise eine Siliziumoxidschicht mit einer Dicke von 20 bis 40 nm im Bodenbereich der Source- und Drainvertiefungen ausgebildet.

Alternativ zur thermischen Oxidation kann auch ein sogenanntes SELOX-Verfahren (Selective Oxid Deposition Process) zur selektiven Abscheidung einer Isolierschicht nur im Bodenbereich der Source- und Drainvertiefungen SV und DV durchgeführt werden. Demzufolge sind die Tiefen für die Source- und Drainvertiefungen abhängig von einem jeweils ausgewählten Herstellungsverfahren für die Vertiefungs-Bodenisolationsschicht 9 zu wählen. Hinsichtlich der weiteren technischen Details insbesondere des SELOX-Verfahrens wird insbesondere auf die Literaturstelle N. Elbel, et al "A new STI-process based on selective oxide deposition" at Symposium on VLSI-Technology 1998 verwiesen.

Die Isolations-Maskenschicht 8 erlaubt demzufolge nicht nur, die horizontalen und die vertikalen Flächen separat zu oxidieren, sondern reduziert darüber hinaus den mechanischen Stress im Kanalbereich.

Gemäß Figur 3E wird ferner die verbleibende Isolations-Maskenschicht 8 auch an den Seitenwänden der Source- und Drainvertiefungen SV und DV entfernt und werden Vertiefungs-Seitenwandisolationsschichtgen 8A in den freigelegten Seitenwandbereichen der Vertiefungen ausgebildet. Genauer gesagt wird zur Entfernung der dünnen Nitridschicht 8 an den Seitenwänden ein kurzzeitiger Ätzschritt und anschließend eine thermische Oxidation bei einer Temperatur von ca. 800°C oder eine Nass-Oxidation zur Herstellung einer ca. 5 bis 20 nm dicken Vertiefungs-Seitenwandisolationsschicht 8A durchgeführt. Vorzugsweise werden die Vertiefungs-Bodenisolationsschicht 9 sowie die Vertiefungs-Seitenwandisolationsschicht 8A als Siliziumdioxidschichten ausgebildet.

Nachfolgend wird nunmehr ein Auffüllen der zumindest teilweise isolierten Source- und Drainvertiefungen SV und DV mit einer Füllschicht durchgeführt, wobei vorzugsweise zunächst eine Keimschicht bzw. Seedlayer 10 zur Realisierung einer späteren selektiven Abscheidung von Polysilizium ausgebildet wird. Beispielsweise erfolgt eine Abscheidung einer dünnen dotierten oder undotierten amorphen oder polykristallinen Halbleiterschicht, wobei vorzugsweise Silizium oder SiGe verwendet wird, jedoch auch alternative Materialien als Keimschicht 10 verwendet werden können. Anschließend erfolgt zur Ausbildung einer Keim-Schutzschicht 11 eine kurze Oxidation oder Nitrierung der Keimschicht 10 und abschließend eine Ausbildung einer Keim-Maskenschicht 12, wobei vorzugsweise eine Resistabscheidung ganzflächig durchgeführt wird. Nach einer Planarisierung der Keim-Maskenschicht 12 mittels beispielsweise eines chemisch-mechanischen Polierverfahrens (CMP) unter Verwendung der Keim-Schutzschicht 11 als Stoppschicht erhält man die in Figur 3E dargestellte Schnittansicht.

Gemäß Figur 3F wird anschließend die Keim-Maskenschicht 12 bis in die Source- und Drainvertiefungen SV und DV zurückgebildet, wobei beispielsweise eine Resist-Ätzung nach einer vorbestimmten Zeit durchgeführt wird. Eine derartige Rückbildung kann relativ genau durchgeführt werden, da die Höhe des Gatestapels üblicherweise sehr genau bekannt ist. Unter Verwendung der bis in die Source- und Drainvertiefungen zurückgebildeten Keim-Maskenschicht 12 erfolgt nunmehr ein teilweises Entfernen der Keim-Schutzschicht 11, d.h. die Oxid- und/oder Nitridschicht werden bis auf den von der Keim-Maskenschicht 12 bedeckten Bereich entfernt. Anschließend erfolgt ein Entfernen der zurückgebildeten Keim-Maskenschicht 12, wobei vorzugsweise ein Resiststrip durchgeführt wird.

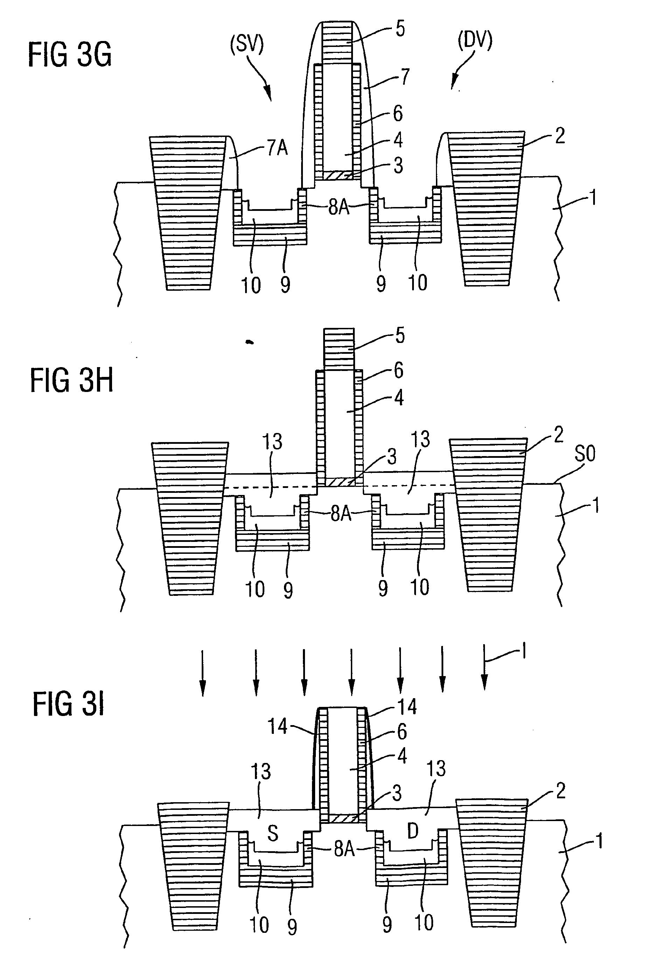

Gemäß Figur 3G wird nachfolgend unter Verwendung der in den Source- und Drainvertiefungen SV und DV verbleibenden Keim-Schutzschicht 11 als Maske wird nunmehr die Keimschicht 10 teilweise entfernt, wobei beispielsweise ein nasschemisches Silizium-Ätzverfahren durchgeführt wird. Abschließend wird auch die verbliebene Keim-Schutzschicht 11 vollständig entfernt. Zum Entfernen der Keim-Schutzschicht 11 wird wiederum ein Nitrid- und/oder ein Oxid-Ätzverfahren durchgeführt.

Die in den Source- und Drainvertiefungen SV und DV verbleibende amorphe oder polykristalline Keimschicht 10 erlaubt nunmehr eine selektive Abscheidung bzw. ein Aufwachsen von Halbleitermaterial auf dieser Schicht, wobei die restlichen Bereiche, die von Oxid bedeckt sind, von dieser Aufwachsschicht 13 freibleiben.

Gemäß Figur 3H werden zunächst die Spacer 7 am Gatestapel sowie die Spacer 7A an der flachen Grabenisolierung 2 entfernt, um die Kanal-Anschlussbereiche KA freizulegen. Vorzugsweise wird dies mittels einer nasschemischen Nitridätzung durchgeführt.

Optional kann zur Verhinderung einer Körnerbildung während eines nachfolgenden Aufwachsvorganges im Kanal-Anschlussbereich eine sehr dünne Interface-Schicht (nicht dargestellt) beispielweise aus Siliziumdioxid oder Siliziumnitrid ausgebildet werden. Anschließend erfolgt das Ausbilden der Aufwachsschicht 13 auf der Keimschicht 10 bis in einen Bereich der Substratoberfläche SO, wobei insbesondere eine (zu Siliziumdioxid) selektive Abscheidung von dotiertem oder undotiertem amorphen oder polykristallinen Halbleitermaterial bis zu einer Dicke von ca. 50 bis 400 nm erfolgt. Bei diesem Schritt werden insbesondere die unterschiedlichen Prozessbedingungen für die Abscheidung von amorphem oder polykristallinem Silizium auf verschiedenen Unterlagen ausgenutzt. Es entsteht somit eine sogenannte "raised source/drain"-Struktur.

Gemäß Figur 3I werden in einem nachfolgenden Schritt Implantations-Spacer 14 an den Seitenwänden des Gatestapels bzw. der Gate-Seitenwandisolationsschicht 6 ausgebildet. Vorzugsweise bestehen diese Implantations-Spacer 14 wiederum aus einer Siliziumnitridschicht. Anschließend kann die Hartmaskenschicht 5 unter Verwendung einer Oxidätzung entfernt werden, wobei die Grabenisolierungen 2 und die TEOS-Hartmaskenschicht zurückgebildet werden, jedoch die Gate-Seitenwandisolationsschichten 6 von den Implantations-Spacern 14 geschützt werden. Abschließend erfolgt eine Implantation I von Dotierstoffen zur Dotierung der freigelegten Gateschicht 4 sowie der Aufwachsschicht 13 und gegebenenfalls der Keimschicht 10. Diese Implantation erfolgt wie üblich mittels Resist-Maskentechnik, wobei zur Aktivierung der Dotierstoffe ferner ein thermischer Ausheilschritt durchgeführt werden kann.

Die Anschlüsse von Source und Drain erfolgen nunmehr über eine Ausdiffusion aus diesen hochdotierten Polysiliziumschichten, wobei wegen der hohen Diffusionskonstante entlang der Korngrenzen das dotierte polykristalline bzw. amorphe Halbleitermaterial wie eine unendliche Dotierstoffquelle wirkt. Die sich daraus ergebenden Vorteile sind sehr steile Diffusionsflanken und hohe Dotierungen. Da die Implantation I der Source- und Draingebiete S und D unmittelbar in das amorphe oder polykristalline Halbleitermaterial stattfindet, wird die Unterdiffusion der Kanal-Anschlussbereiche KA nicht von Implantationsdefekten bestimmt, da diese an den Polysilizium-Korngrenzen rekombinieren. Aufgrund dieser Tatsache ist es möglich, größere Temperaturbudgets einzusetzen, um eine bessere Prozesskontrolle und eine höhere Aktivierung der Dotierstoffe zu erreichen.

Alternativ zu der Abscheidung von undotiertem Halbleitermaterial bzw. Silizium kann auch insitu-dotiertes Halbleitermaterial abgeschieden werden. Hierzu wird der Wafer mit einer Maskenschicht bedeckt und dann selektiv der Bereich für z.B. NFET-Transistoren geöffnet. Nur in diesem Bereich wird dann dotiertes Halbleitermaterial abgeschieden. Für PFET-Transistoren wird der Vorgang entsprechend wiederholt.

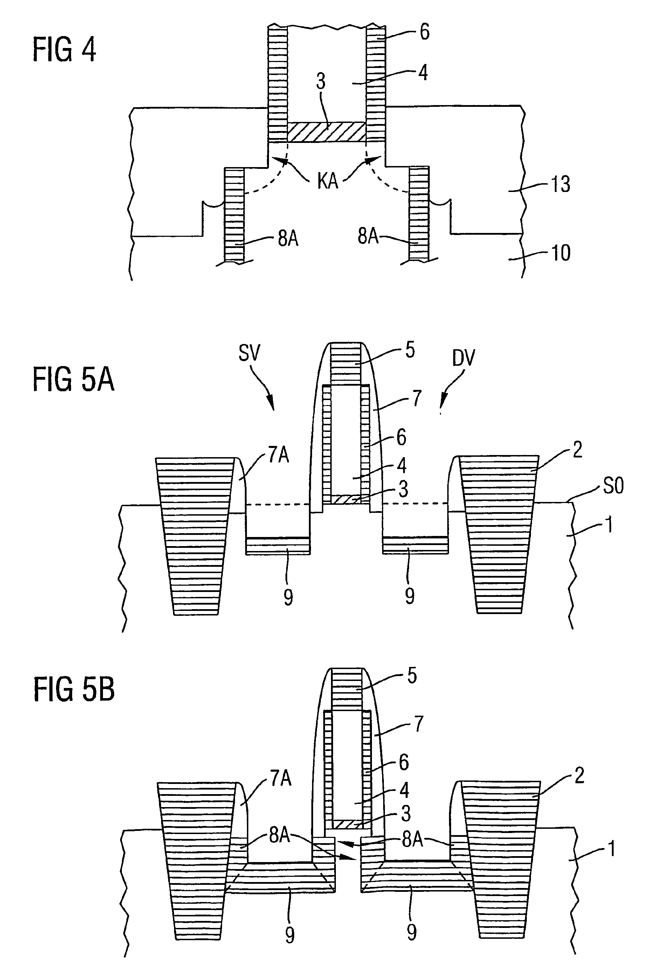

Figur 4 zeigt eine vereinfachte Teilschnittansicht zur Darstellung der Kanal-Anschlussbereiche bei Verwendung von undotiertem oder dotiertem Halbleitermaterial gemäß dem vorstehend beschriebenen dritten Ausführungsbeispiel.

Figuren 5A und 5B zeigen vereinfachte Schnittansichten wesentlicher Verfahrensschritte bei der Herstellung eines Feldeffekttransistors mit lokaler Source-/Drainisolation gemäß einem Ausführungsbeispiel, wobei gleiche Bezugszeichen gleiche oder entsprechende Elemente bzw. Schichten wie in den Figuren 1 bis 4 bezeichnen und auf eine wiederholte Beschreibung nachfolgend verzichtet wird.

Gemäß dem vorliegenden Ausführungsbeispiel werden sogenannte Feldeffekttransistoren mit "fully depleted"-Kanalgebieten, d.h. vollständig verarmten Kanalgebieten beschrieben. Derartige Feldeffekttransistoren sind insbesondere bei der Realisierung von schnellen Kurzkanaltransistoren erwünscht, da sich dadurch wesentlich erhöhte Geschwindigkeiten sowie Taktfrequenzen realisieren lassen.

Die Figuren 5A und 5B entsprechen hierbei den Verfahrensschritten gemäß 3D und 3E, wobei zur Realisierung der vollständig verarmten Kanalgebiete eine Vertiefungs-Seitenwandisolationsschicht 8A ausgebildet wird, die sich weit in einen Bereich unterhalb des Gatedielektrikums 3 erstreckt. Genauer gesagt wird beispielsweise mittels Oxidation der freigelegten Seitenwände der Source- und Drainvertiefungen SV und DV eine große Dicke der Vertiefungs-Seitenwandisolationsschicht 8A erzeugt, die in einem Bereich von 20 bis 30 nm liegt. Aufgrund dieser hohen Dicke ergibt sich ein Abschnüren des sogenannten Bodys bzw. Kanalgebietes, wodurch man eine vollständig verarmte Struktur im Kanalgebiet erhält.

Die Vorteile eines derartigen Feldeffekttransistors liegen insbesondere bei Realisierung von Schaltungen mit Transistoren unterschiedliche Kanallängen darin, dass die Transistoren mit kurzer Kanallänge die in Figur 5B dargestellten fully depleted-Strukturen mit ihren zugehörigen Leistungsvorteilen aufweisen, wie sie auch aus SOI-Halbleiterschaltungen bekannt sind, während die Transistoren mit großer Kanallänge, wie sie für Mixed-Signal-Schaltungen auch verwendet werden, weiterhin das Verhalten von Bulk-Transistoren zeigen und demzufolge in gewohnter Weise einen Wannenanschluss zur Festlegung eines Potentials im Kanalgebiet besitzen. Demzufolge können auf diese Weise quasi-SOI-Transistoren und sogenannte Bulk-Transistoren gleichzeitig auf einem Chip ohne Verwendung von zusätzlichen Masken sozusagen selbstjustierend bzw. automatisch hergestellt werden. Dies bedeutet insbesondere einen Vorteil für SoC-Schaltungen, wo schnelle Digitalschaltungen und Mixed-Signal-Schaltungen auf einem Chip realisiert werden sollen.

Die Erfindung wurde vorstehend an Hand von Silizium-Halbleiterschaltungen beschrieben. Sie ist jedoch nicht darauf beschränkt und umfasst in gleicher Weise auch Halbleiterschaltungen mit alternativen Halbleitermaterialien. In gleicher Weise können insbesondere für die Gateschicht und die Füllschicht auch alternative Materialien verwendet werden.

## Patentansprüche

1. Feldeffekttransistor mit lokaler Source-/Drainisolation mit
einem Halbleitersubstrat (1);
einer Sourcevertiefung (SV) und einer Drainvertiefung (DV), die im Halbleitersubstrat (1) voneinander beabstandet ausgebildet sind;
einer Vertiefungs-Isolationsschicht (VI), die zumindest in einem Bodenbereich der Sourcevertiefung (SV) und der Drainvertiefung (DV) ausgebildet ist;
einer elektrisch leitenden Füllschicht (F), die zur Realisierung von Source- und Draingebieten (S, D) und zum Auffüllen der Source- und Drainvertiefungen (SV, DV) an der Oberfläche der Vertiefungs-Isolationsschicht (VI) ausgebildet ist;
einem Gatedielektrikum (3), das an der Substratoberfläche (SO) zwischen der Source- und Drainvertiefung (SV, DV) ausgebildet ist; und
einer Gateschicht (4), die an der Oberfläche des Gatedielektrikums (3) ausgebildet ist,
wobei die Source- und Drainvertiefungen (SV, DV) in einem oberen Bereich eine Verbreiterung (V1) mit einer vorbestimmten Tiefe (d1) zur Realisierung von definierten Kanal-Anschlussbereichen (KA) aufweisen, wobei
die Vertiefungs-Isolationsschicht (VI) ferner eine im Seitenwandbereich der Source- und Drainvertiefungen (SV, DV) ausgebildete Vertiefungs-Seitenwandisolationsschicht (8A) aufweist, die sich in einen Bereich unterhalb des Gatedielektrikums (3) hinein erstreckt jedoch das Gatedielektrikum (3) nicht berührt.

2. Feldeffekttransistor nach Patentanspruch 1, **dadurch gekennzeichnet, dass** die elektrisch leitende Füllschicht (F) eine Keimschicht (10) zur Verbesserung eines Abscheidens in den Source- und Drainvertiefungen (SV, DV) aufweist.

3. Feldeffekttransistor nach einem der Patentansprüche 1 oder 2, **dadurch gekennzeichnet, dass** die Gateschicht (4) eine an ihren Seitenwänden ausgebildete Gateisolationsschicht (6) aufweist.

4. Feldeffekttransistor nach einem der Patentansprüche 1 bis 3, **dadurch gekennzeichnet, dass** er von flachen Grabenisolierungen (2) begrenzt ist.

5. Feldeffekttransistor nach einem der Patentansprüche 1 bis 4, **dadurch gekennzeichnet, dass** er laterale Strukturen < 100 nm aufweist.

6. Feldeffekttransistor nach einem der Patentansprüche 1 bis 5, **dadurch gekennzeichnet, dass** die Source- und Drainvertiefungen (SV, DV) eine Tiefe (d1+d2) von 50 nm bis 300 nm aufweisen.

7. Verfahren zur Herstellung eines Feldeffekttransistors mit lokaler Source-/Drainisolation mit den Schritten:
a) Ausbilden und Strukturieren eines Gatestapels mit einer Gateschicht (4) und einem Gatedielektrikum (3) auf einem Halbleitersubstrat (1);
b) Ausbilden von Source- und Drainvertiefungen (SV, DV, V1, V2) am Gatestapel (3, 4, 5, 6) im Halbleitersubstrat (1);
c) Ausbilden einer Vertiefungs-Isolationsschicht (8, 8A, 9) zumindest in einem Bodenbereich der Source- und Drainvertiefungen (SV, DV); und
d) Auffüllen der zumindest teilweise isolierten Source- und Drainvertiefungen (SV, DV) mit einer Füllschicht (F; 10, 13) zur Realisierung von Source- und Draingebieten (S, D), wobei in Schritt b) aufeinanderfolgend
erste Vertiefungen (V1) zur Realisierung von Kanal-Anschlussbereichen (KA) im Halbleitersubstrat (1);
Spacer (7) am Gatestapel (3, 4, 5, 6); und
zweite Vertiefungen (V2) unter Verwendung der Spacer (7) als Maske in den ersten Vertiefungen (V1) und im Halbleitersubstrat (1) ausgebildet werden; und in Schritt c) die Vertiefungs-Isolationsschicht derart ausgebildet wird,
dass sie ferner eine im Seitenwandbereich der Source- und
Drainvertiefungen (SV, DV) ausgebildete Vertiefungs-Seitenwandisolationsschicht (8A) aufweist, die sich in einen Bereich unterhalb des Gatedielektrikums (3) hinein erstreckt jedoch das Gatedielektrikum (3) nicht berührt.

8. Verfahren nach Patentanspruch 7, **dadurch gekennzeichnet, dass** in Schritt a)
ein STI-Verfahren zur Ausbildung von flachen Grabenisolierungen (2);
eine Implantation zur Ausbildung von Wannen- und/oder KanalDotiergebieten im Halbleitersubstrat (1);
eine thermische Oxidation zur Ausbildung des Gatedielektrikums (3);
eine Abscheidung von Halbleitermaterial zur Ausbildung der Gateschicht (4);
eine TEOS-Abscheidung zur Ausbildung einer Hartmaskenschicht (5) ;
ein lithografisches Verfahren zur Strukturierung von zumindest der Gateschicht (4) unter Verwendung der Hartmaskenschicht (5); und
eine weitere thermische Oxidation zur Ausbildung einer Gate-Seitenwandisolationsschicht (6) an den Seitenwänden der Gateschicht (4) durchgeführt wird.

9. Verfahren nach Patentanspruch 7 oder 8, **dadurch gekennzeichnet, dass** die ersten Vertiefungen (V1) unter Verwendung des Gatestapels (3, 4, 5, 6) und der flachen Grabenisolationsschicht (2) als Maske bis zu einer ersten Tiefe (d1) von 10 bis 50 nm von der Substratoberfläche (SO) durch anisotropes Ätzen ausgebildet werden.

10. Verfahren nach Patentanspruch 7 bis 9, **dadurch gekennzeichnet, dass** vor dem Ausbilden der Spacer (7) eine erste Halbleiter-Schutzschicht zumindest an den Kanal-Anschlussbereichen (KA) ausgebildet wird.

11. Verfahren nach einem der Patentansprüche 7 bis 10, **dadurch gekennzeichnet, dass** die Spacer (7) durch konformales Abscheiden von Siliziumnitrid und anisotropes Rückätzen ausgebildet werden.

12. Verfahren nach einem der Patentansprüche 7 bis 11, **dadurch gekennzeichnet, dass** die zweiten Vertiefungen (V2) bis zu einer Tiefe (d1+d2) von 50 bis 300 nm von der Substratoberfläche (SO) durch anisotropes Ätzen ausgebildet werden.

13. Verfahren nach einem der Patentansprüche 7 bis 12, **dadurch gekennzeichnet, dass**
in Schritt c)
eine Isolations-Maskenschicht (8) in den Source- und Drainvertiefungen (SV, DV) ausgebildet und zumindest im Bodenbereich wieder entfernt wird; und
jeweils eine Vertiefungs-Bodenisolationsschicht (9) im freigelegten Bodenbereich ausgebildet wird.

14. Verfahren nach Patentanspruch 13, **dadurch gekennzeichnet, dass** ferner
die verbleibende Isolations-Maskenschicht (8) auch an den Seitenwänden der Vertiefungen entfernt; und
die Vertiefungs-Seitenwandisolationsschichten (8A) in den freigelegten Seitenwandbereichen der Vertiefungen ausgebildet werden.

15. Verfahren nach Patentanspruch 13 oder 14, **dadurch gekennzeichnet, dass**
als Isolations-Maskenschicht (8) eine Siliziumnitridschicht; und
als Vertiefungs-Boden- und/oder Seitenwand-Isolationsschicht (9, 8A) eine Siliziumdioxidschicht ausgebildet wird.

16. Verfahren nach einem der Patentansprüche 7 bis 15, **dadurch gekennzeichnet, dass**
in Schritt d)
d1) eine Keimschicht (10), eine Keim-Schutzschicht (11) und eine Keim-Maskenschicht (12) ganzflächig ausgebildet wird;
d2) die Keim-Maskenschicht (12) bis in die Source- und Drainvertiefungen (SV, DV) zurückgebildet wird;
d3) die Keim-Schutzschicht (11) unter Verwendung der Keim-Maskenschicht (12) als Maske teilweise entfernt wird;
d4) die zurückgebildete Keim-Maskenschicht (12) entfernt wird;
d5) die Keimschicht (10) unter Verwendung der Keim-Schutzschicht (11) als Maske teilweise entfernt wird;
d6) die Keim-Schutzschicht (11) vollständig entfernt wird; und
d7) eine Aufwachsschicht (13) auf der Keimschicht (10) bis in einen Bereich der Substratoberfläche (SO) ausgebildet wird.

17. Verfahren nach Patentanspruch 16, **dadurch gekennzeichnet, dass**
in Schritt d6) ferner die Spacer (7) entfernt werden; und in Schritt d)
d8) Implantations-Spacer (14) am Gatestapel (3, 4, 6) ausgebildet;
d9) die Hartmaskenschicht (5) entfernt; und
d10) eine Implantation (I) zur Dotierung der Gateschicht (4) sowie der Aufwachsschicht (13) durchgeführt werden.

## Claims

1. Field-effect transistor with local source-drain insulation, having
a semiconductor substrate (1);
a source depression (SV) and a drain depression (DV), which are formed in a manner spaced apart from one another in the semiconductor substrate (1) ;
a depression insulation layer (VI), which is formed at least in a bottom region of the source depression (SV) and of the drain depression (DV); an electrically conductive filling layer (F), which is formed for realizing source and drain regions (S, D) and for filling the source and drain depressions (SV, DV) at the surface of the depression insulation layer (VI);
a gate dielectric (3), which is formed at the substrate surface (SO) between the source and drain depressions (SV, DV); and
a gate layer (4), which is formed at the surface of the gate dielectric (3), the source and drain depressions (SV, DV) having, in an upper region, a widening (V1) with a predetermined depth (d1) for realizing defined channel connection regions (KA), the depression insulation layer (VI) furthermore having a depression sidewall insulation layer (8A), which is formed in the sidewall region of the source and drain depressions (SV, DV) and which extends into a region below the gate dielectric (3) but does not touch the gate dielectric (3).

2. Field-effect transistor according to Patent Claim 1, **characterized in that** the electrically conductive filling layer (F) has a seed layer (10) for improving a deposition in the source and drain depressions (SV, DV).

3. Field-effect transistor according to Patent Claim 1 or 2, **characterized in that** the gate layer (4) has a gate insulation layer (6) formed at its sidewalls.

4. Field-effect transistor according to one of Patent Claims 1 to 3, **characterized in that** it is bounded by shallow trench isolations (2).

5. Field-effect transistor according to one of Patent Claims 1 to 4, **characterized in that** it has lateral structures < 100 nm.

6. Field-effect transistor according to one of Patent Claims 1 to 5, **characterized in that** the source and drain depressions (SV, DV) have a depth (d1+d2) of 50 nm to 300 nm.

7. Method for fabricating a field-effect transistor with local source/drain insulation, having the following steps:
a) formation and patterning of a gate stack with a gate layer (4) and a gate dielectric (3) on a semiconductor substrate (1);
b) formation of source and drain depressions (SV, DV, V1, V2) at the gate stack (3, 4, 5, 6) in the semiconductor substrate (1);
c) formation of a depression insulation layer (8, 8A, 9) at least in a bottom region of the source and drain depressions (SV, DV); and
d) filling of the at least partially insulated source and drain depressions (SV, DV) with a filling layer (F; 10, 13) for realizing source and drain regions (S, D),
in step b), successively
first depressions (V1) being formed for realizing channel connection regions (KA) in the semiconductor substrate (1);
spacers (7) being formed at the gate stack (3, 4, 5, 6); and
second depressions (V2) being formed using the spacers (7) as a mask in the first depressions (V1) and in the semiconductor substrate (1); and in step c)
the depression insulation layer being formed in such a way that it furthermore has a depression sidewall insulation layer (8A), which is formed in the sidewall region of the source and drain depressions (SV, DV) and which extends into a region below the gate dielectric (3) but does not touch the gate dielectric (3).

8. Method according to Patent Claim 7, **characterized in that**, in step a),
an STI method is carried out for forming shallow trench isolations (2);
an implantation is carried out for forming well and/or channel doping regions in the semiconductor substrate (1);
a thermal oxidation is carried out for forming the gate dielectric (3);
a deposition of semiconductor material is carried out for forming the gate layer (4);
a TEOS deposition is carried out for forming a hard mask layer (5);
a lithographic method is carried out for patterning at least the gate layer (4) using the hard mask layer (5), and
a further thermal oxidation is carried out for forming a gate sidewall insulation layer (6) at the sidewalls of the gate layer (4).

9. Method according to Patent Claim 7 or 8, **characterized in that** the first depressions (V1) are formed using the gate stack (3, 4, 5, 6) and the shallow trench isolation layer (2) as a mask down to a first depth (d1) of 10 to 50 nm from the substrate surface (SO) by means of anisotropic etching.

10. Method according to Patent Claims 7 to 9, **characterized in that**, before the formation of the spacers (7), a first semiconductor protection layer is formed at least at the channel connection regions (KA).

11. Method according to one of Patent Claims 7 to 10, **characterized in that** the spacers (7) are formed by conformal deposition of silicon nitride and anisotropic etching-back.

12. Method according to one of Patent Claims 7 to 11, **characterized in that** the second depressions (V2) are formed down to a depth (d1+d2) of 50 to 300 nm from the substrate surface (SO) by means of anisotropic etching.

13. Method according to one of Patent Claims 7 to 12, **characterized in that**, in step c),
an insulation mask layer (8) is formed in the source and drain depressions (SV, DV) and removed again at least in the bottom region; and
a depression bottom insulation layer (9) is in each case formed in the uncovered bottom region.

14. Method according to Patent Claim 13, **characterized in that**, furthermore,
the remaining insulation mask layer (8) is also removed at the sidewalls of the depressions; and the depression sidewall insulation layers (8A) are formed in the uncovered sidewall regions of the depressions.

15. Method according to Patent Claim 13 or 14, **characterized in that**
a silicon nitride layer is formed as insulation mask layer (8); and
a silicon dioxide layer is formed as depression bottom and/or sidewall insulation layer (9, 8A).

16. Method according to one of Patent Claims 7 to 15, **characterized in that**, in step d),
d1) a seed layer (10), a seed protection layer (11) and a seed mask layer (12) are formed over the whole area;
d2) the seed mask layer (12) is caused to recede right into the source and drain depressions (SV, DV);
d3) the seed protection layer (11) is partially removed using the seed mask layer (12) as a mask;
d4) the seed mask layer (12) that was caused to recede is removed;
d5) the seed layer (10) is partially removed using the seed protection layer (11) as a mask;
d6) the seed protection layer (11) is completely removed; and
d7) a growth layer (13) is formed on the seed layer (10) right into a region of the substrate surface (SO).

17. Method according to Patent Claim 16, **characterized in that**,
in step d6), furthermore, the spacers (7) are removed; and
in step d),
d8) implantation spacers (14) are formed at the gate stack (3, 4, 6);
d9) the hard mask layer (5) is removed; and
d10) an implantation (I) is carried out for doping the gate layer (4) and also the growth layer (13).

## Revendications

1. Transistor à effet de champ ayant une isolation locale source/drain et comprenant
un substrat (1) semi-conducteur ;
une cavité (SV) de source et une cavité (DV) de drain, qui sont formées à distance l'une de l'autre dans le substrat (1) semi-conducteur ;
une couche (VI) isolante de cavité, qui est formée au moins dans une partie de fond de la cavité (SV) de source et de la cavité (DV) de drain ;
une couche (F) de remplissage conductrice de l'électricité, qui est formée à la surface de la couche (VI) isolante de cavité pour la réalisation des zones (S, D) de source et de drain et pour le remplissage des cavités (SV, DV) de source et de drain ;
un diélectrique (3) de grille, qui est formé à la surface (SO) du substrat entre la cavité (SV) de source et la cavité (DV) de drain et
une couche (4) de grille, qui est formée à la surface du diélectrique (3) de grille,
dans lequel les cavités (SV, DV) de source et de drain ont, dans une partie supérieure, un élargissement (V1) d'une profondeur (d1) déterminée à l'avance pour la réalisation de parties (KA) de borne de canal définies, dans lequel la couche (VI) isolante de cavité a en outre une couche (8A) isolante de paroi latérale de cavité, formée dans une partie de paroi latérale des cavités (SV, DV) de source et de drain, qui s'étend dans une partie en dessous du diélectrique (3) de grille, mais ne touche pas le diélectrique (3) de grille.

2. Transistor à effet de champ suivant la revendication 1, **caractérisé en ce que** la couche (F) de remplissage conductrice de l'électricité a une couche (10) de germe pour améliorer un dépôt dans les cavités (SV, DV) de source et de drain.

3. Transistor à effet de champ suivant la revendication 1 ou 2, **caractérisé en ce que** la couche (4) de grille a une couche (6) isolante de grille formée sur ses parois latérales.

4. Transistor à effet de champ suivant l'une des revendications 1 à 3, **caractérisé en ce qu'**il est délimité par des isolations (2) planes en sillon.

5. Transistor à effet de champ suivant l'une des revendications 1 à 4, **caractérisé en ce qu'**il a des structures latérales < à 100 nm.

6. Transistor à effet de champ suivant l'une des revendications 1 à 5, **caractérisé en ce que** les cavités (SV, DV) de source et de drain ont une profondeur (d1+d2) de 50 nm à 300 nm.

7. Procédé de fabrication d'un transistor à effet de champ ayant une isolation de source/drain locale comprenant les stades dans lesquels :
a) on forme et on structure un empilement de grille ayant une couche (4) de grille et un diélectrique (3) de grille sur un substrat (1) semi-conducteur ;
b) on forme des cavités (SV, DV, V1, V2) de source et de drain sur l'empilement (3, 4, 5, 6) de grille dans le substrat (1) semi-conducteur;
c) on forme une couche (8, 8A, 9) isolante de cavité au moins dans une partie de fond des cavités (SV, DV) de source et de drain et
d) on remplit les cavités (SV, DV) de source et de drain, isolées au moins en partie, d'une couche (F ; 10, 13) de remplissage pour la réalisation de zones (S, D) de source et de drain,
dans lequel, dans le stade b), successivement,
on forme des premières cavités (V1) pour la réalisation de parties (KA) de borne de canal dans le substrat (1) semi-conducteur ;
on forme des espaceurs (7) sur l'empilement (3, 4, 5, 6) de grille et
on forme des deuxièmes cavités (V2) en utilisant les espaceurs (7) comme masques dans les premières cavités (V1) et dans le substrat (1) semi-conducteur et dans le stade c) on forme la couche isolante de cavité de manière à ce qu'elle ait en outre une couche (8A) isolante de paroi latérale de cavité, formée dans la partie de paroi latérale des cavités (SV, DV) de source et de drain, couche qui s'étend dans une partie en dessous du diélectrique (3) de grille, mais qui ne touche pas le diélectrique (3) de grille.

8. Procédé suivant la revendication 7, **caractérisé en ce que** dans le stade a) on effectue
un procédé STI pour former des isolations (2) planes en sillon ;
une implantation pour former des zones dotées de cuvette et/ou de canal dans le substrat (1) semi-conducteur ;
une oxydation thermique pour former le diélectrique (3) de grille ;
un dépôt de matériau semi-conducteur pour former la couche (4) de grille ;
un dépôt TEOS pour former une couche (5) de masque dur ;
un procédé lithographique de structuration d'au moins la couche (4) de grille en utilisant la couche (5) de masque dur et
une autre oxydation thermique pour former une couche (6) isolante de paroi latérale de grille sur les parois latérales de la couche (4) de grille.

9. Procédé suivant la revendication 7 ou 8, **caractérisé en ce que** l'on forme, par attaque anisotrope, les premières cavités (V1), en utilisant l'empilement (3, 4, 5, 6) de grille et la couche (2) isolante plane en sillon comme masque jusqu'à une première profondeur (d1) de 10 à 50 nm à partir de la surface (SO) du substrat.

10. Procédé suivant la revendication 7 à 9, **caractérisé en ce qu'**avant de former l'espaceur (7), on forme une première couche de protection de semi-conducteur au moins sur les parties (KA) de borne de canal.

11. Procédé suivant l'une des revendications 7 à 10, **caractérisé en ce qu'**on forme les espaceurs (7) par dépôt conforme de nitrure de silicium et par attaque anisotrope en retrait.

12. Procédé suivant l'une des revendications 7 à 11, **caractérisé en ce que** l'on forme par attaque anisotrope des deuxièmes cavités (V2) jusqu'à une profondeur (d1+d2) de 50 à 300 nm à partir de la surface (SO) du substrat.

13. Procédé suivant l'une des revendications 7 à 12, caractérisé en ce
dans le stade c)
on forme une couche (8) de masque isolante dans les cavités (SV, DV) de source et de drain et on l'élimine à nouveau au moins dans la partie de fond et
on forme respectivement une couche (9) isolante de fond de cavité dans la partie de fond mise à nu.

14. Procédé suivant la revendication 13, **caractérisé en ce qu'**en outre on élimine aussi la couche (8) de masque isolante restante sur les parois latérales des cavités et
on forme les couches (8A) isolantes de paroi latérale de cavité dans les parties de paroi latérale mises à nu des cavités.

15. Procédé suivant la revendication 13 ou 14, **caractérisé en ce que** l'on forme,
comme couche (8) de masque isolante, une couche de nitrure de silicium et,
comme couche (9, 8A) isolante de fond de cavité et/ou de paroi latérale, une couche de dioxyde de silicium.

16. Procédé suivant l'une des revendications 7 à 15, caractérisé en ce
dans le stade d)
d1) on forme une couche (10) de germe, une couche (11) de protection de germe et une couche (12) de masque de germe sur toute la surface ;
d2) on forme en retour la couche (12) de masque de germe jusque dans les cavités (SV, DV) de source et de drain ;
d3) on élimine en partie la couche (11) de protection de germe en utilisant la couche (12) de masque de germe comme masque ;
d4) on élimine la couche (12) de masque de germe formée en retour ;
d5) on élimine en partie la couche (10) de germe en utilisant la couche (11) de protection de germe comme masque ;
d6) on élimine complètement la couche (11) de protection de germe et
d7) on forme une couche (13) de croissance sur la couche (10) de germe jusque dans une partie de la surface (SO) du substrat.

17. Procédé suivant la revendication 16, **caractérisé en ce que**, dans le stade d6), on élimine en outre l'espaceur (7) et
dans le stade d)
d8) on forme un espaceur (14) d'implantation sur l'empilement (3, 4, 6) de grille ;
d9) on élimine la couche (5) de masque dur et
d10) on effectue une implantation (I) de dopage de la couche (4) de grille ainsi que de la couche (13) de croissance.
